# FASCICULE DE BREVET EUROPEEN

(11) **EP 4 187 797 B1**
(45) Date de publication et mention de la délivrance du brevet: **22.05.2024**
(21) Numéro de dépôt: 22209225.6
(22) Date de dépôt: 23.11.2022
(51) Int. Cl.: H04B 1/10, G01R 23/163, G01R 23/165, G01R 29/08

(54) **DISPOSITIF DE DETECTION ET D'IDENTIFICATION DE SIGNAUX RF**
VORRICHTUNG ZUR DETEKTION UND IDENTIFIZIERUNG VON HF-SIGNALEN
DEVICE FOR DETECTING AND IDENTIFYING RF SIGNALS

(30) Priorité: 29.11.2021 FR 2112677
(43) Date de publication de la demande: 31.05.2023
(73) Titulaire: Commissariat à l'énergie atomique et aux énergies alternatives, 75015 Paris (FR)
(72) Inventeur: MORCHE, Dominique, 38054 GRENOBLE CEDEX 09 (FR); PEKCOKGULER, Naci, 38054 GRENOBLE CEDEX 09 (FR)
(74) Mandataire: Brevalex

(56) Documents cités:
- KR-A- 20100 104 019
- US-A1- 2006 128 308
- US-B1- 8 160 163

## Description

### DOMAINE TECHNIQUE

L'invention concerne le domaine des circuits intégrés pour la réception et la détection de signaux radio fréquence, et notamment pour la détection de spectre radio fréquence avec de fortes contraintes de consommation. L'invention peut s'appliquer en particulier à la réalisation de circuits destinés à la localisation géographique via la détection de spectre radio fréquence environnant.

### ETAT DE LA TECHNIQUE ANTERIEURE

Les bandes de fréquences sans licence, telle que la bande ISM (bande industrielle, scientifique et médicale) de 2,4 GHz, sont généralement très exploitées. En raison du taux d'occupation élevé, les liaisons de communication fonctionnant dans ces bandes doivent tolérer les interférences des autres utilisateurs. Dans certaines circonstances, l'interférence peut être trop élevée pour être tolérée, ce qui impose de détecter d'autres fréquences non utilisées. Pour cela, des applications de détection de spectre sont utilisées.

La précision, la latence et l'efficacité spectrale sont les principaux critères considérés dans les applications de détection de spectre. Ces applications cherchent généralement à détecter des bandes de fréquences vides dans un spectre donné, les interférences et la coexistence avec d'autres utilisateurs.

Les méthodes utilisées dans la détection du spectre peuvent être classées en deux catégories : des méthodes classiques et des méthodes d'apprentissage approfondi. Les méthodes classiques mettent en oeuvre du traitement statistique des signaux et une classification basée sur des caractéristiques conçues par des experts. Les méthodes d'apprentissage approfondi consistent en des réseaux de neurones qui sont capables d'apprendre et de reconnaître les caractéristiques des signaux avec très peu de prétraitement du signal d'entrée.

Les méthodes classiques basées sur la probabilité exploitent des arguments statistiques des signaux de communication et effectuent des tests de rapport de vraisemblance pour la classification. Ces méthodes permettent d'obtenir des performances optimales en minimisant les fausses alertes. Cependant, la complexité de calcul requise est très élevée, surtout lorsque le nombre de paramètres inconnus est important, ce qui les rend inadaptées aux applications de faible puissance.

La classification en fonction des caractéristiques des signaux permet d'obtenir des performances sous-optimales, mais n'exige que des calculs simples. Les méthodes basées sur les caractéristiques sont faciles à mettre en oeuvre et sont compatibles avec des applications de faible puissance. Toutefois, la multiplication du nombre des normes de communication rend cette technique moins intéressante.

Les méthodes basées sur l'analyse temporelle des signaux sont moins efficaces contre le bruit et sont utilisées avec des algorithmes de reconnaissance de formes pour augmenter les performances à faible SNR (rapport signal sur bruit). La détection des fronts dans un signal transformé en ondelettes peut être utilisée pour la détection de bande vide. La transformation en ondelettes est intéressante car elle est capable de réduire les effets du bruit, et elle contient des informations sur le temps et la fréquence des signaux. L'autocorrélation peut également être utilisée pour distinguer des modulations multi-porteuses. Des statistiques d'ordre supérieur peuvent être utilisées pour la reconnaissance de la modulation, car elles éliminent l'effet du bruit et sont résistantes aux rotations de phase. L'analyse de cyclicité donne la corrélation d'une composante de fréquence dans le spectre avec d'autres fréquences. La cyclo-stationnarité d'un signal modulé provient de répétitions périodiques causées par le débit de symboles, le débit de données, et ainsi de suite. Par conséquent, elle convient aux demandes de reconnaissance aveugle.

Toutes les caractéristiques énumérées ci-dessus sont utilisées avec des classificateurs tels que l'arbre de décision, la recherche des k-voisins les plus proches, les machines à vecteurs de support et les réseaux neuronaux artificiels.

La principale difficulté dans la conception de systèmes de classification basés sur les caractéristiques est la sélection des caractéristiques plutôt qu'une sélection de classificateurs.

Les méthodes d'apprentissage approfondi utilisent des DNN, des LSTM (réseau récurrent à mémoire court et long terme), des CNN (réseau neuronal convolutif) et des architectures à réseaux résiduels (ResNet). Comme les réseaux neuronaux profonds peuvent performer des tâches de classification très complexes, les applications se concentrent sur la reconnaissance et la distinction des caractéristiques complexes. La reconnaissance de la modulation, la communication, la reconnaissance des normes, l'identification des interférences et la détection des signaux radar sont les principales applications des méthodes d'apprentissage approfondi sur les signaux radiofréquences.

A l'opposé, il est possible de réaliser de la détection de spectre en se basant sur une simple détection d'énergie et en observant le temps d'émission des systèmes présents. Cette technique est très basse consommation mais très peu robuste dans un contexte de spectre très utilisé. En effet, la détection de l'énergie ne suppose aucune interférence, la détection comprimée suppose que le spectre soit clairsemé, et la radio cognitive suppose que l'on dispose d'un circuit front-end RF de type analyseur de spectre. Ces hypothèses sont le plus souvent non valables ou irréalistes.

US 8160163 B1 divulgue plusieurs algorithmes ou détecteurs pour extraire des caractéristiques ou estimer une pluralité de paramètres d'un signal reçu pour un contrôle du spectre.

### EXPOSÉ DE L'INVENTION

Un but de la présente invention est de proposer un dispositif de détection de signaux RF ne présentant pas les inconvénients précédemment décrits pour les dispositifs de l'art antérieur.

Pour cela, la présente invention propose un dispositif de détection de signaux RF, comportant au moins :
- un premier circuit de détection de croisement de seuil comprenant une entrée couplée à une entrée du dispositif ;
- un premier circuit de détection d'énergie comprenant une entrée couplée à l'entrée du dispositif;
- un deuxième circuit de détection de croisement de seuil comprenant une entrée couplée à une sortie du premier circuit de détection d'énergie ;
et comportant en outre un circuit de commande configuré pour :
- réaliser, par le premier circuit de détection de croisement de seuil, une détection d'au moins une première fréquence de croisement de seuil dans une bande de fréquences RF prédéterminée ;
- réaliser, par le premier circuit de détection d'énergie, une détection d'énergie dans la bande de fréquences RF prédéterminée ;
- réaliser, par le deuxième circuit de détection de croisement de seuil, une détection d'au moins une deuxième fréquence de croisement de seuil d'un premier signal d'énergie délivré en sortie du premier circuit de détection d'énergie ;
- déterminer, au moins à partir des première et deuxième fréquences de croisement de seuil et du premier signal d'énergie, si un seul signal RF est présent dans la bande de fréquences RF.

Ce dispositif propose de réaliser une détection de signaux RF à partir d'informations extraites par des circuits électroniques simples, et donc avec une très faible consommation électrique.

Ce dispositif propose notamment d'utiliser de manière judicieuse trois caractéristiques, ou « features », du ou des signaux présents dans la bande de fréquences RF afin de déterminer si un seul signal est présent dans cette bande. La détermination de ces trois caractéristiques peut être réalisée par des circuits électroniques bien plus simples que lorsque des méthodes d'apprentissage sont utilisées. La solution proposée est également plus robuste qu'une détection de spectre réalisée par une unique détection d'énergie.

Chacun des circuits de détection de croisement de seuil peut être configuré pour compter, pendant une durée donnée, le nombre de fois où le signal appliqué sur son entrée croise une valeur seuil.

Lorsqu'aucun signal RF n'est détecté dans la bande de fréquences RF, le circuit de commande peut être configuré pour répéter l'étape de détection d'énergie avec un rythme de répétition ajusté en fonction de caractéristiques d'au moins un signal RF destiné à être détecté et identifié par le dispositif et/ou d'un taux d'occupation de la bande de fréquences RF. Ainsi, la consommation du dispositif peut être réduite grâce à cet ajustement du rythme avec lequel le dispositif réalise la détection d'énergie, le dispositif pouvant être éteint lorsqu'il ne réalise pas la détection d'énergie.

Lorsqu'un seul signal RF est détecté dans la bande de fréquences RF, le circuit de commande peut être configuré pour répéter l'étape de détection d'énergie de manière à définir l'évolution de l'énergie dudit signal RF détecté en fonction du temps, et le dispositif peut comporter en outre un ou plusieurs circuits de détermination d'au moins l'une des caractéristiques suivantes à partir des valeurs de l'énergie dudit signal RF : bande passante, temps d'établissement, pente initiale, valeur après établissement, écart-type après établissement, amplitude maximale (également appelé « ringing amplitude » en anglais).

Dans ce cas, le dispositif peut comporter en outre un dispositif de classification du signal RF détecté au moins en fonction des première et deuxième fréquences de croisement de seuil et du premier signal d'énergie.

Le dispositif peut comporter en outre au moins un premier filtre passe-bande dont les fréquences de coupure haute et/ou basse sont ajustables, et comprenant une sortie couplée à une entrée du premier circuit de détection d'énergie.

Dans ce cas, le circuit de commande peut être configuré pour répéter les étapes de détection d'énergie, de détection des première et deuxième fréquences de croisement de seuil et de détermination de la présence d'un seul signal RF dans la bande de fréquences RF en modifiant les valeurs des fréquences de coupure haute et/ou basse du premier filtre passe-bande de manière à réaliser ces étapes pour différentes sous-bandes de la bande de fréquences RF, et/ou de manière à centrer et réduire la bande passante du premier filtre passe-bande autour d'une fréquence centrale dudit seul signal RF présent dans la bande de fréquences RF.

Selon une autre configuration, le dispositif peut comporter en outre :
- plusieurs deuxièmes filtres passe-bande configurés pour réaliser un filtrage dans des sous-bandes de fréquences différentes incluses dans la bande de fréquences RF ;
- plusieurs deuxièmes circuits de détection d'énergie comprenant des entrées couplées à des sorties des deuxièmes filtres passe-bande ;
- plusieurs troisièmes circuits de détection de croisement de seuil comprenant des entrées couplées aux sorties des deuxièmes filtres passe-bande ;
- plusieurs quatrièmes circuits de détection de croisement de seuil comprenant des entrées couplées à des sorties des deuxièmes circuits de détection d'énergie ;
et le circuit de commande peut être configuré pour :
- réaliser, par le troisième circuit de détection de croisement de seuil, une détection d'au moins une troisième fréquence de croisement de seuil dans les sous-bandes de fréquences ;
- réaliser, par les deuxièmes circuits de détection d'énergie, une détection d'énergie dans les sous-bandes de fréquences ;
- réaliser, par le quatrième circuit de détection de croisement de seuil, une détection d'au moins une quatrième fréquence de croisement de seuil de deuxièmes signaux d'énergie délivrés en sortie des deuxièmes circuits de détection d'énergie ;
- déterminer, au moins à partir des troisième et quatrième fréquences de croisement de seuil et des deuxièmes signaux d'énergie, la présence d'un seul signal RF dans chacune des sous-bandes de fréquences.

Dans ce cas, les fréquences de coupure haute et/ou basse des deuxièmes filtres passe-bande peuvent être ajustables, et le circuit de commande peut être configuré pour répéter les étapes de détection d'énergie dans les sous-bandes de fréquences, de détection des troisième et quatrième fréquences de croisement de seuil et de détermination de la présence d'un seul signal RF dans chacune des sous-bandes de fréquences en modifiant les valeurs des fréquences de coupure haute et/ou basse des deuxièmes filtres passe-bande de manière à réaliser ces étapes pour différentes sous-bandes de la bande de fréquences RF, et/ou de manière à centrer et réduire les bandes passantes des deuxièmes filtres passe-bande autour de fréquences centrales de signaux RF présents dans les sous-bandes de fréquences.

En outre, le circuit de commande peut être configuré pour répéter la mise en oeuvre des étapes de détection d'énergie dans les sous-bandes de fréquences, de détection des troisième et quatrième fréquences de croisement de seuil et de détermination de la présence d'un seul signal RF dans chacune des sous-bandes de fréquences en choisissant des instants de mise en oeuvre de ces étapes de manière à éviter la présence d'un ou plusieurs signaux non souhaités dans le spectre obtenu en sortie des deuxièmes filtres passe-bande et/ou en en annulant un ou plusieurs signaux précédemment identifiés.

Le premier circuit de détection d'énergie et/ou chaque deuxième circuit de détection d'énergie peut comporter un circuit de calcul du carré ou de la valeur absolu d'un signal appliqué en entrée dudit circuit de détection d'énergie.

En variante, le premier circuit de détection d'énergie et/ou chaque deuxième circuit de détection d'énergie peut comporter un circuit détecteur d'enveloppe d'un signal appliqué en entrée dudit circuit de détection d'énergie, du fait qu'une détection d'une enveloppe d'un signal correspond à une détection d'énergie.

De plus, le premier circuit de détection d'énergie et/ou chaque deuxième circuit de détection d'énergie peut comporter un filtre passe-bas comprenant une entrée couplée à une sortie du circuit de calcul, une sortie du filtre passe-bas pouvant former une sortie du circuit de détection d'énergie.

Le dispositif peut comporter en outre au moins un premier filtre passe-haut dont une entrée est couplée à une sortie du premier circuit de détection d'énergie et dont une sortie est couplée à une entrée du deuxième circuit de détection de croisement de seuil, et/ou au moins un deuxième filtre passe-haut dont une entrée est couplée à des sorties des deuxièmes circuits de détection d'énergie et dont une sortie est couplée à une entrée du quatrième circuit de détection de croisement de seuil.

Dans ce cas, le dispositif peut comporter en outre un dispositif de détection de valeur crête comprenant une entrée couplée à une sortie du premier filtre passe-haut, et dont une sortie est couplée à une entrée d'un circuit de détermination de valeur d'amplitude maximale, ou de « ringing amplitude », et/ou au moins un deuxième dispositif de détection de valeur crête comprenant une entrée couplée à une sortie du deuxième filtre passe-haut, et dont une sortie est couplée à une entrée d'un circuit de détermination de valeur d'amplitude maximale.

Le dispositif peut comporter en outre :
- un amplificateur faible bruit comprenant une entrée destinée à recevoir le ou les signaux RF présents dans la bande de fréquences RF ;
- un multiplieur comprenant une première entrée couplée à la sortie de l'amplificateur faible bruit, et une deuxième entrée couplée à une sortie d'un oscillateur local ;
- un troisième filtre passe-bande comprenant une entrée couplée à la sortie du multiplieur et une sortie couplée à l'entrée du premier circuit de détection d'énergie et, lorsque le dispositif comprend les deuxièmes circuits de détection d'énergie, à l'entrée des deuxièmes circuits de détection d'énergie.

L'invention concerne également un dispositif de localisation comportant au moins un dispositif de détection de signal RF tel que décrit précédemment. Un tel dispositif de localisation peut être utilisé pour fonctionner dans la bande de fréquences RF comprise entre 2,4 GHz et 2,5 GHz.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement, sous la forme d'un logigramme, les fonctions mises en oeuvre par un dispositif de détection et d'identification de signal RF, objet de la présente invention ;
- la figure 2 représente schématiquement un dispositif de détection et d'identification de signal RF, objet de la présente invention, selon un mode de réalisation particulier ;
- la figure 3 représente un exemple d'évolution dans le temps de l'énergie dans une bande de fréquences RF en présence de trois signaux.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSE DETAILLE DE MODES DE REALISATION PARTICULIERS

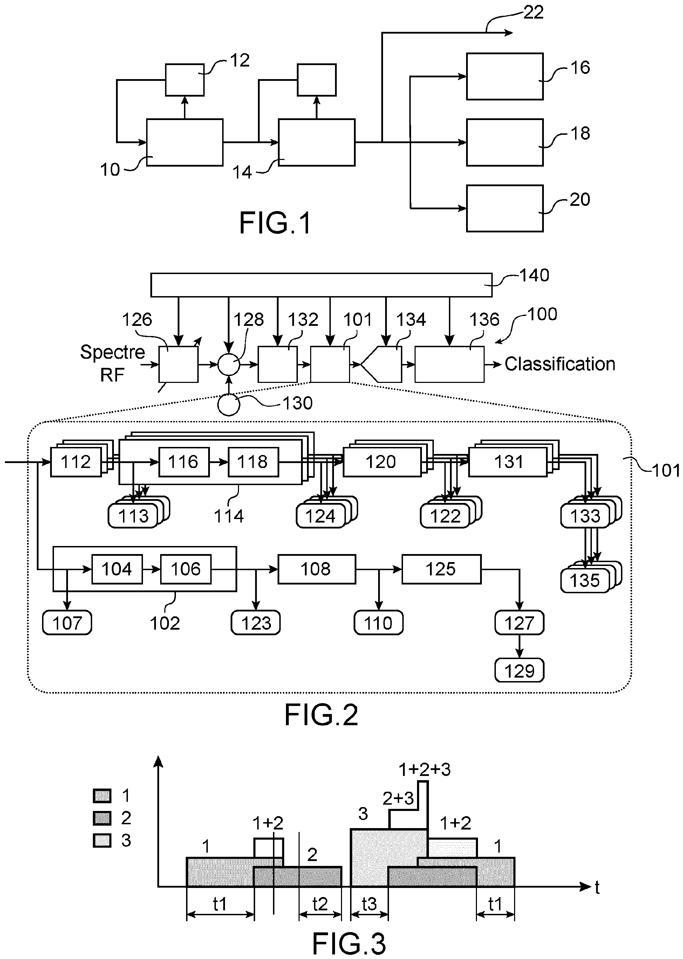

Un dispositif 100 de détection de signaux RF selon un mode de réalisation est décrit ci-dessus en lien avec les figures 1 et 2, la figure 1 représentant schématiquement, sous la forme d'un logigramme, les fonctions mises en oeuvre par le dispositif 100, et la figure 2 représentant schématiquement le dispositif 100 selon ce mode de réalisation particulier.

Le dispositif 100 réalise une détection d'énergie dans une bande de fréquences RF prédéterminée reçue en entrée du dispositif 100, par exemple par l'intermédiaire d'une antenne de réception (non représentée), dans le but de déterminer si un seul signal est présent dans cette bande de fréquences. Dans le mode de réalisation particulier décrit ici, la bande de fréquences RF dans laquelle un ou plusieurs signaux sont recherchés correspond à la bande de fréquences WiFi comprise entre 2,4 GHz et 2,5 GHz. Cette détection d'énergie est représentée sur la figure 1 par le bloc 10. Cette détection d'énergie est par exemple réalisée avec un fort gain et une faible linéarité.

Pour réaliser cette détection d'énergie, le dispositif 100 comporte un premier circuit de détection d'énergie 102. Ce premier circuit 102 est non-linéaire. Sur l'exemple de la figure 2, le premier circuit 102 comporte un circuit 104 de calcul du carré ou de la valeur absolu du ou des signaux présents dans la bande de fréquences RF investiguée. Un tel circuit 104 de calcul du carré du ou des signaux RF comporte par exemple un redresseur qui ne garde que les signaux positifs ou un circuit de redressement à base de diodes ou un circuit calculant la valeur absolue du signal. Ce calcul du carré du ou des signaux RF peut être réalisé à partir d'un mélangeur ou d'un circuit différentiel comme décrit par exemple dans le document « Performance of a Simple Architecture of an Analog CMOS Detector for MB-UWB Receiver » de M. Mroue et al., IEEE ICUWB, Sep 2009, Vancouver, Canada. pp.107-112. En variante, le circuit 104 peut correspondre à un circuit détecteur d'enveloppe.

Le premier circuit 102 comporte également, sur l'exemple de la figure 2, un filtre passe-bas 106 servant à stabiliser le signal délivré en sortie du circuit 104 en moyennant l'énergie de ce signal sur une certaine période. La fréquence de coupure de ce filtre 106 est avantageusement choisie telle qu'elle ne soit ni trop basse (ce qui permet d'avoir une bonne précision de l'énergie mais avec, en contrepartie, une longue durée de mesure) ni trop haute (mesure rapide mais peu précise). A titre d'exemple, la fréquence de couple du filtre passe-bas 106 peut être comprise entre la valeur de la bande passante du signal et 1/5 de cette valeur. Un tel filtre passe-bas 106 comporte par exemple une source de courant couplée à une capacité.

Cette détection d'énergie est répétée jusqu'à détecter une énergie non nulle dans la bande de fréquences RF, ce qui signifie qu'au moins un signal est présent dans la bande de fréquences RF dans laquelle la détection est réalisée. En l'absence de détection d'énergie, le rythme avec lequel le premier circuit 102 réalise la détection d'énergie et/ou la durée pendant laquelle chaque détection d'énergie est réalisée par le premier circuit 102 sont ajustés en fonction des caractéristiques d'un ou des signaux recherchés et/ou d'un taux d'occupation de la bande de fréquences RF. Cet ajustement du rythme de répétition avec lequel le premier circuit 102 réalise la détection d'énergie est représenté sur la figure 1 par le bloc 12.

Entre deux détections d'énergie consécutives, le dispositif 100 peut être mis dans un état de fonctionnement réduit, ou veille, dans lequel certains circuits du dispositif 100 ne sont pas alimentés, ce qui permet de réduire la consommation électrique du dispositif 100.

Lorsqu'une énergie non nulle est détectée dans la bande de fréquences RF, le dispositif 100 détermine si un signal RF présent dans la bande de fréquences RF (bloc 14 de la figure 1).Pour cela, sur l'exemple de la figure 2, le signal RF reçu est appliqué en entrée d'un premier circuit de détection de croisement de seuil 107. Ce circuit 107 va compter, pendant une période donnée, combien de fois le signal détecté va croiser une valeur seuil qui correspond par exemple à 0 (avec dans ce cas le circuit 107 qui correspond dans ce cas à un détecteur ZCR (« Zero Crossing » en anglais). La valeur obtenue en sortie du circuit 107 va permettre de déterminer la fréquence moyenne du signal reçu et donne donc une image de la répartition de l'énergie dans la bande de fréquences considérée.

Cette détermination de fréquence est également réalisée sur le signal représentant l'énergie du signal RF. Pour cela, le signal obtenu en sortie du premier circuit 102 est appliqué en entrée d'un premier filtre passe-haut 108 qui permet de supprimer la composante continu du ou des signaux présents dans la bande de fréquences RF. Le signal obtenu en sortie du premier filtre passe-haut 108 est appliqué en entrée d'un deuxième circuit de détection de croisement de seuil 110 fonctionnant de manière analogue au circuit 107. La valeur obtenue en sortie du circuit 110 va permettre de déterminer la fréquence moyenne de l'énergie du signal reçu.

A partir au moins des trois caractéristiques déterminées (première fréquence de croisement de seuil obtenue en sortie du circuit 107, énergie détectée par le circuit 102, deuxième fréquence de croisement de seuil obtenue en sortie du circuit 110), le dispositif 100 détermine si un seul signal RF est présent dans la bande de fréquences RF considérée. L'énergie reçue donne la probabilité qu'un signal soit présent ; le rythme des croisements de seuil donne la valeur de la fréquence porteuse du signal RF et donc sa position dans le spectre, et les croisements de seuil en sortie de la détection d'énergie donne une estimation de la bande passante et donc du type de signal présent.

Lorsqu'un ou plusieurs signaux RF sont détectés dans la bande de fréquences RF, les étapes de détection d'énergie peuvent être répétées de manière à définir l'évolution de l'énergie du ou des signaux RF détectés en fonction du temps.

Dans l'exemple de réalisation représenté sur la figure 2, le dispositif 100 comporte en outre des circuits de détermination de caractéristiques du ou des signaux RF détectés :
- un circuit 123 déterminant, à partir du signal obtenu en sortie du premier circuit 102 le temps d'établissement du ou des signaux RF détectés. A titre d'exemple, pour mesurer le temps d'établissement, le circuit 123 peut réaliser une comparaison entre deux intégrations différentes de l'énergie détectée obtenues en utilisant des fréquences de coupure différentes dans le filtre passe-bas 106 du circuit de détection d'énergie 102. Le temps d'établissement est alors déterminé en détectant le croisement des deux fonctions obtenues, ou en échantillonnant plusieurs valeurs obtenues en sortie des deux intégrations ;
- un détecteur de valeur crête 125 recevant en entrée les signaux délivrés en sortie du premier filtre passe-haut 108. Ce détecteur 125, également appelé « peak detector » en anglais, comporte par exemple un circuit intégrateur ;
- un circuit 127 déterminant, à parti d'un signal délivré par le détecteur 125, l'amplitude maximale du ou des signaux RF ;
- un circuit 129 déterminant, à partir d'un signal délivré par le circuit 127, la bande passante du ou des signaux RF.

D'autres caractéristiques du ou des signaux RF détectés peuvent être déterminées, comme par exemple la pente initiale de l'énergie et/ou la valeur après établissement de l'énergie et/ou l'écart-type après établissement de ce ou ces signaux.

Dans le dispositif 100 selon le mode de réalisation particulier décrit ici, la détection de signaux est réalisée simultanément dans toute la bande de fréquences RF par les circuits précédemment décrits, et également dans une ou plusieurs sous-bandes du spectre RF afin d'affiner la caractérisation du ou des signaux présents dans la bande de fréquences RF. Pour cela, la détection et la caractérisation est réalisée dans toute la bande du spectre RF par les éléments 102, 107, 108, 110, 123, 125, 127 et 129 précédemment décrits qui forment une première chaîne de détection, et la détection dans une ou plusieurs sous-bandes de fréquences est réalisée par d'autres éléments similaires et qui forment une ou plusieurs autres chaînes de détection.

Ainsi, le dispositif 100 comporte en outre plusieurs filtres passe-bande 112 recevant en entrée le spectre RF à analyser, chaque chaîne de détection comportant l'un de ces filtres passe-bande 112. La sortie de chacun des filtres 112 est couplée en entrée d'un troisième circuit de détection de croisement de seuil 113 par exemple identique au circuit 107 précédemment décrit. La sortie de chacun des filtres 112 est également couplée à l'entrée d'un deuxième circuit de détection d'énergie 114. Ces deuxièmes circuits 114 sont par exemple identiques au premier circuit 102 précédemment décrit et comportent par exemple chacun un circuit 116 de calcul du carré ou de la valeur absolu de la sous-bande du spectre RF appliquée sur son entrée, et un filtre passe-bas 118 servant à stabiliser le signal délivré en sortie du circuit 116. Les sorties de ces chaînes de détection sont couplées chacune à l'entrée d'un deuxième filtre passe-haut 120 qui permet de supprimer la composante continu du ou des signaux présents dans chaque sous-bande du spectre RF, et à l'entrée d'un circuit 124 de détermination de temps d'établissement, par exemple identique au circuit 123. Le signal obtenu à la sortie de chaque deuxième filtre passe-haut 120 est envoyé à l'entrée d'un deuxième circuit de détection de croisement de seuil 122, par exemple identique au circuit 110, et à l'entrée d'un détecteur de valeur crête 131, par exemple identique au détecteur 125. La sortie de chaque détecteur 131 est couplée à l'entrée d'un circuit 133 par exemple identique au circuit 127, et la sortie de chaque circuit 133 est couplée à l'entrée d'un circuit 135 par exemple identique au circuit 129.

D'autres caractéristiques du ou des signaux RF présents dans les sous-bandes RF peuvent être déterminées, comme par exemple la pente initiale de l'énergie et/ou la valeur après établissement de l'énergie et/ou l'écart-type après établissement de ce ou ces signaux.

En fonction des informations obtenues avec les éléments précédemment décrits du dispositif 100 et des informations recherchées, plusieurs étapes supplémentaires peuvent être mises en oeuvre par le dispositif 100, correspondant à plusieurs modes de fonctionnement du dispositif 100, afin de compléter ces précédentes étapes et affiner la détection et l'identification des signaux présents dans le spectre RF.

Dans un premier mode de fonctionnement, si les informations précédemment obtenues sont suffisantes, il est possible de réaliser une classification et/un comptage des signaux précédemment identifiés. La classification est réalisée à partir des caractéristiques des signaux qui ont été déterminées. Ce premier mode est représenté sur la figure 1 par le bloc 16. La classification réalisée peut correspondre par exemple à un classement des signaux détectés suivant leur type (WiFi, Bluetooth, Micro-ondes, etc.), leur standard (802.11b, 802.11g, etc.), leur bande passante, leur débit, etc.

Dans un deuxième mode de fonctionnement, les étapes précédemment mises en oeuvre peuvent être répétées dans une ou plusieurs autres sous-bandes du spectre RF comprenant un ou plusieurs signaux recherchés. Ce deuxième mode correspond au bloc 18 représenté sur la figure 1.

Dans un troisième mode, il est possible de répéter les étapes précédemment mises en oeuvre en masquant un ou plusieurs signaux non souhaités dans le spectre, lorsque de tels signaux non souhaités ont été précédemment identifiés. Pour cela, il est possible de choisir les instants de mise en oeuvre des étapes d'identification de fréquence de manière à éviter la présence de ce ou ces signaux non souhaités dans le spectre analysé et/ou d'annuler ce ou ces signaux précédemment identifiés dans le spectre analysé (via une soustraction de ce ou ces signaux). Cela revient à augmenter la dynamique de traitement de la chaîne de réception en séparant les signaux grâce aux deuxièmes filtres passe-bande 112 en tirant profit de l'analyse du ou des signaux les plus forts dans un filtre dédié et annulant ce ou ces signaux par l'intermédiaire d'une boucle de rétroaction. Ce troisième mode est symbolisé par le bloc 20 sur la figure 1.

La figure 3 illustre un exemple d'évolution dans le temps de l'énergie dans une bande de fréquences RF en présence de trois signaux référencés 1, 2 et 3. On voit sur cette figure qu'en choisissant judicieusement les instants de mise en oeuvre des différentes étapes précédemment, il est possible de mettre en oeuvre ces étapes en présence du signal souhaité uniquement. Par exemple, sur la figure 3, les périodes t1 correspondent aux périodes pendant lesquelles seul le signal 1 est présent, la période t2 correspond à une période pendant laquelle seul le signal 2 est présent, et la période t3 correspond à une période pendant laquelle seul le signal 3 est présent.

Si le spectre est trop dense ou trop complexe pour être analysé par le dispositif 100, il est possible alors de recourir à une chaîne de réception classique à haute dynamique pour traiter les signaux. Cette possibilité est représentée par la flèche portant la référence 22 sur la figure 1.

Le dispositif 100 peut passer d'un mode de fonctionnement à l'autre suivant les résultats obtenus. Le temps de commutation d'un mode à l'autre peut être très rapide, comme en établissement une boucle de rétroaction dès la détection d'un signal fort.

Outre les éléments précédemment décrits qui forment ensemble un circuit de détection 101 au sein du dispositif 100, le dispositif 100 représenté sur la figure 2 comporte également :
- un amplificateur faible bruit 126 comprenant une entrée configurée pour recevoir la bande de fréquence RF ;
- un multiplieur 128 comprenant une première entrée couplée à la sortie de l'amplificateur faible bruit 126, et une deuxième entrée couplée à une sortie d'un oscillateur local 130 ;
- un troisième filtre passe-bande 132 comprenant une entrée couplée à la sortie du multiplieur 128 et une sortie couplée à l'entrée du circuit de détection 101, c'est-à-dire aux entrées des filtres passe-bande 112 et à l'entrée du premier circuit 102.
- un convertisseur analogique - numérique 134 recevant en entrée les caractéristiques des signaux détectés ;
- un dispositif 136 de classification et/ou de comptage des signaux détectés.
Pour réaliser une classification des signaux, le dispositif 136 peut mettre en oeuvre des algorithmes déterministes ou un traitement des données de type intelligence artificielle telle que de l'apprentissage automatique, ou « machine learning » en anglais.

Le pilotage du dispositif 100, c'est-à-dire l'envoi des signaux dans les différents circuits du dispositif 100 et le paramétrage de ces circuits, est réalisé par un circuit de commande 140.

Dans une variante de réalisation du dispositif 100, il est possible que le dispositif 100 ne comporte que la première chaîne de détection formée par les éléments 102, 107, 108 et 110 et non les deuxièmes chaînes de détection formées par les éléments 112, 114, 120 et 122. Dans ce cas, le dispositif 100 comporte une filtre passe-bande, par exemple similaire à l'un des filtres 112, couplé à l'entrée du premier circuit 102 de détection d'énergie. Ainsi, le dispositif 100 peut réaliser séquentiellement des détections de signaux au sein de différentes sous-bandes de la bande de fréquences RF. De manière avantageuse, les détections de signaux sont réalisées dans des bandes fréquentielles d'abord larges, puis réduites, afin de pénaliser le moins possible la vitesse de fonctionnement du dispositif 100.

Dans les exemples de réalisation précédemment décrits, les circuits 110, 122 de détection de croisement de seuil sont configurés pour détecter un croisement avec une valeur seuil égale à zéro. En variante, il est possible que cette valeur seuil soit différente de 0.

Les différents circuits du dispositif 100 peuvent être réalisés sous la forme d'une puce de semi-conducteur.

De manière avantageuse, le dispositif 100 peut être utilisé en tant que dispositif de localisation via la détection de signaux WiFi. Le dispositif 100 peut dans ce cas extraire des données d'identification de l'émetteur des signaux WiFi détectés et ainsi être capable d'effectuer une localisation de l'objet équipé du dispositif 100. Un tel dispositif de localisation peut par exemple être réalisé sous la forme d'une puce intégrée dans une étiquette de localisation, et a pour avantage de disposer d'une fonctionnalité de localisation très basse consommation.

En effet, pour déterminer une position approximative d'un émetteur de signal RF, il est intéressant d'identifier quels sont les signaux radios disponibles, par exemple en déterminant quelles sont les stations de base à proximité du dispositif 100, quelles bornes WiFi sont disponibles ou encore quelles bandes de signaux TV sont utilisées. Contrairement à un récepteur WiFi qui scanne régulièrement les fréquences ISM (industriel, scientifique et médical) pour détecter la présence de signaux WiFi, et qui peut dépenser beaucoup d'énergie inutilement lorsque peu de signaux radio sont disponibles, notamment dans les zones rurales, le dispositif 100 permet de détecter la présence de ces signaux avec une très basse consommation en ayant un système dédié à cette fonctionnalité. Par exemple, une fois qu'un signal WiFi est détecté par le dispositif 100, il est possible d'allumer un récepteur WiFi du dispositif 100 qui va aller lire l'identifiant de la borne émettrice détectée, en récupérant l'en-tête du signal détecté. L'identifiant récupéré peut être envoyé et comparé dans une base de données pour identifier la borne émettrice, et ainsi localiser cette borne et donc également localiser le dispositif 100. Dans le dispositif 100, le récepteur WiFi n'est utilisé que lorsque cela est nécessaire, ce qui diminue l'énergie dissipée.

Le dispositif 100 peut également être utilisé pour surveiller le niveau d'interférence dans une ou plusieurs bandes de fréquences donnée et ainsi adapter la consommation d'un système de communication utilisant cette ou ces bandes de fréquences.

## Revendications

1. Dispositif (100) de détection de signaux RF, comportant au moins :
- un premier circuit de détection de croisement de seuil (107) comprenant une entrée couplée à une entrée du dispositif (100) ;
- un premier circuit de détection d'énergie (102) comprenant une entrée couplée à l'entrée du dispositif (100) ;
- un deuxième circuit de détection de croisement de seuil (110) comprenant une entrée couplée à une sortie du premier circuit de détection d'énergie (102) ;
et comportant en outre un circuit de commande (140) configuré pour :
- réaliser, par le premier circuit de détection de croisement de seuil (107), une détection d'au moins une première fréquence de croisement de seuil dans une bande de fréquences RF prédéterminée ;
- réaliser, par le premier circuit de détection d'énergie (102), une détection d'énergie dans la bande de fréquences RF prédéterminée ;
- réaliser, par le deuxième circuit de détection de croisement de seuil (110), une détection d'au moins une deuxième fréquence de croisement de seuil d'un premier signal d'énergie délivré en sortie du premier circuit de détection d'énergie (102) ;
- déterminer, au moins à partir des première et deuxième fréquences de croisement de seuil et du premier signal d'énergie, si un seul signal RF est présent dans la bande de fréquences RF ;
et dans lequel chacun des circuits de détection de croisement de seuil est configuré pour compter, pendant une durée donnée, le nombre de fois où le signal appliqué sur son entrée croise une valeur seuil.

2. Dispositif (100) selon la revendication 1, dans lequel, lorsqu'aucun signal RF n'est détecté dans la bande de fréquences RF, le circuit de commande est configuré pour répéter l'étape de détection d'énergie avec un rythme de répétition ajusté en fonction de caractéristiques d'au moins un signal RF destiné à être détecté et identifié par le dispositif (100) et/ou d'un taux d'occupation de la bande de fréquences RF.

3. Dispositif (100) selon l'une des revendications précédentes, dans lequel, lorsqu'un seul signal RF est détecté dans la bande de fréquences RF, le circuit de commande est configuré pour répéter l'étape de détection d'énergie de manière à définir l'évolution de l'énergie dudit signal RF détecté en fonction du temps, et dans lequel le dispositif (100) comporte en outre un ou plusieurs circuits (123, 127, 129) de détermination d'au moins l'une des caractéristiques suivantes à partir des valeurs de l'énergie dudit signal RF : bande passante, temps d'établissement, pente initiale, valeur après établissement, écart-type après établissement, amplitude maximale.

4. Dispositif (100) selon l'une des revendications précédentes, comportant en outre un dispositif (136) de classification du signal RF détecté au moins en fonction des première et deuxième fréquences de croisement de seuil et du premier signal d'énergie.

5. Dispositif (100) selon l'une des revendications précédentes, comportant en outre au moins un premier filtre passe-bande dont les fréquences de coupure haute et/ou basse sont ajustables, et comprenant une sortie couplée à une entrée du premier circuit de détection d'énergie (102).

6. Dispositif (100) selon la revendication 5, dans lequel le circuit de commande est configuré pour répéter les étapes de détection d'énergie, de détection des première et deuxième fréquences de croisement de seuil et de détermination de la présence d'un seul signal RF dans la bande de fréquences RF en modifiant les valeurs des fréquences de coupure haute et/ou basse du premier filtre passe-bande de manière à réaliser ces étapes pour différentes sous-bandes de la bande de fréquences RF, et/ou de manière à centrer et réduire la bande passante du premier filtre passe-bande autour d'une fréquence centrale dudit seul signal RF présent dans la bande de fréquences RF.

7. Dispositif (100) selon l'une des revendications 1 à 4, comportant en outre :
- plusieurs deuxièmes filtres passe-bande (112) configurés pour réaliser un filtrage dans des sous-bandes de fréquences différentes incluses dans la bande de fréquences RF ;
- plusieurs deuxièmes circuits de détection d'énergie (114) comprenant des entrées couplées à des sorties des deuxièmes filtres passe-bande (112) ;
- plusieurs troisièmes circuits de détection de croisement de seuil (113) comprenant des entrées couplées aux sorties des deuxièmes filtres passe-bande (112) ;
- plusieurs quatrièmes circuits de détection de croisement de seuil (122) comprenant des entrées couplées à des sorties des deuxièmes circuits de détection d'énergie (114) ;
et dans lequel le circuit de commande est configuré pour :
- réaliser, par le troisième circuit de détection de croisement de seuil (113), une détection d'au moins une troisième fréquence de croisement de seuil dans les sous-bandes de fréquences ;
- réaliser, par les deuxièmes circuits de détection d'énergie (114), une détection d'énergie dans les sous-bandes de fréquences ;
- réaliser, par le quatrième circuit de détection de croisement de seuil (122), une détection d'au moins une quatrième fréquence de croisement de seuil de deuxièmes signaux d'énergie délivrés en sortie des deuxièmes circuits de détection d'énergie (114) ;
- déterminer, au moins à partir des troisième et quatrième fréquences de croisement de seuil et des deuxièmes signaux d'énergie, la présence d'un seul signal RF dans chacune des sous-bandes de fréquences.

8. Dispositif (100) selon la revendication 7, dans lequel les fréquences de coupure haute et/ou basse des deuxièmes filtres passe-bande (112) sont ajustables, et dans lequel le circuit de commande est configuré pour répéter les étapes de détection d'énergie dans les sous-bandes de fréquences, de détection des troisième et quatrième fréquences de croisement de seuil et de détermination de la présence d'un seul signal RF dans chacune des sous-bandes de fréquences en modifiant les valeurs des fréquences de coupure haute et/ou basse des deuxièmes filtres passe-bande (112) de manière à réaliser ces étapes pour différentes sous-bandes de la bande de fréquences RF, et/ou de manière à centrer et réduire les bandes passantes des deuxièmes filtres passe-bande (112) autour de fréquences centrales de signaux RF présents dans les sous-bandes de fréquences.

9. Dispositif (100) selon l'une des revendications 7 ou 8, dans lequel le circuit de commande est configuré pour répéter la mise en oeuvre des étapes de détection d'énergie dans les sous-bandes de fréquences, de détection des troisième et quatrième fréquences de croisement de seuil et de détermination de la présence d'un seul signal RF dans chacune des sous-bandes de fréquences en choisissant des instants de mise en oeuvre de ces étapes de manière à éviter la présence d'un ou plusieurs signaux non souhaités dans le spectre obtenu en sortie des deuxièmes filtres passe-bande (112) et/ou en annulant un ou plusieurs signaux précédemment identifiés.

10. Dispositif (100) selon l'une des revendications précédentes, dans lequel le premier circuit de détection d'énergie (102) et/ou, lorsque le dispositif (100) dépend de l'une des revendications 7 à 9, chaque deuxième circuit de détection d'énergie (114) comporte un circuit (104, 116) de calcul du carré ou de la valeur absolu d'un signal appliqué en entrée dudit circuit de détection d'énergie (102, 114).

11. Dispositif (100) selon la revendication 10, dans lequel le premier circuit de détection d'énergie (102) et/ou, lorsque le dispositif (100) dépend de l'une des revendications 7 à 9, chaque deuxième circuit de détection d'énergie (114) comporte un filtre passe-bas (106, 118) comprenant une entrée couplée à une sortie du circuit (104, 116) de calcul, une sortie du filtre passe-bas (106, 118) formant une sortie du circuit de détection d'énergie (102, 114).

12. Dispositif (100) selon l'une des revendications précédentes, comportant en outre au moins un premier filtre passe-haut (108) dont une entrée est couplée à une sortie du premier circuit de détection d'énergie (102) et dont une sortie est couplée à une entrée du deuxième circuit de détection de croisement de seuil (110), et/ou, lorsque le dispositif (100) dépend de l'une des revendications 7 à 9, au moins un deuxième filtre passe-haut (120) dont une entrée est couplée à des sorties des deuxièmes circuits de détection d'énergie (114) et dont une sortie est couplée à une entrée du quatrième circuit de détection de croisement de seuil (122).

13. Dispositif (100) selon la revendication 12, comportant en outre un dispositif de détection de valeur crête (125) comprenant une entrée couplée à une sortie du premier filtre passe-haut (108), et dont une sortie est couplée à une entrée d'un circuit (127) de détermination de valeur d'amplitude maximale, et/ou, lorsque le dispositif (100) dépend de l'une des revendications 7 à 9, au moins un deuxième dispositif de détection de valeur crête (131) comprenant une entrée couplée à une sortie du deuxième filtre passe-haut (120), et dont une sortie est couplée à une entrée d'un circuit (133) de détermination de valeur d'amplitude maximale.

14. Dispositif (100) selon l'une des revendications précédentes, comportant en outre :
- un amplificateur faible bruit (126) comprenant une entrée destinée à recevoir le ou les signaux RF présents dans la bande de fréquences RF ;
- un multiplieur (128) comprenant une première entrée couplée à la sortie de l'amplificateur faible bruit (126), et une deuxième entrée couplée à une sortie d'un oscillateur local (130) ;
- un troisième filtre passe-bande (132) comprenant une entrée couplée à la sortie du multiplieur (128) et une sortie couplée à l'entrée du premier circuit de détection d'énergie (102) et, lorsque le dispositif (100) dépend de l'une des revendications 7 à 9, à l'entrée des deuxièmes circuits de détection d'énergie (114).

15. Dispositif de localisation comportant au moins un dispositif de détection de signal RF selon l'une des revendications précédentes.

## Patentansprüche

1. Vorrichtung (100) zur Erfassung von HF-Signalen, die mindestens umfasst:
- eine erste Schwellenkreuzungserfassungsschaltung (107), die einen Eingang umfasst, der mit einem Eingang der Vorrichtung (100) gekoppelt ist;
- eine erste Energieerfassungsschaltung (102), die einen Eingang umfasst, der mit dem Eingang der Vorrichtung (100) gekoppelt ist;
- eine zweite Schwellenkreuzungserfassungsschaltung (110), die einen Eingang umfasst, der mit einem Ausgang der ersten Energieerfassungsschaltung (102) gekoppelt ist;
und die weiter eine Steuerschaltung (140) umfasst, die so konfiguriert ist, dass sie:
- durch die erste Schwellenkreuzungserfassungsschaltung (107) eine Erfassung mindestens einer ersten Schwellenkreuzungsfrequenz in einem vorbestimmten HF-Frequenzband ausführt;
- durch die erste Energieerfassungsschaltung (102) eine Energieerfassung in dem vorbestimmten HF-Frequenzband ausführt;
- durch die zweite Schwellenkreuzungserfassungsschaltung (110) eine Erfassung mindestens einer zweiten Schwellenkreuzungsfrequenz eines ersten Energiesignals, das am Ausgang der ersten Energieerfassungsschaltung (102) bereitgestellt wird, ausführt;
- mindestens auf Grundlage der ersten und der zweiten Schwellenkreuzungsfrequenz und des ersten Energiesignals bestimmt, ob ein einzelnes HF-Signal in dem HF-Frequenzband vorhanden ist;
und wobei jede der Schwellenkreuzungserfassungsschaltungen so konfiguriert ist, dass sie während einer gegebenen Dauer zählt, wie oft das an ihrem Eingang angelegte Signal einen Schwellenwert kreuzt.

2. Vorrichtung (100) nach Anspruch 1, wobei, wenn kein HF-Signal in dem HF-Frequenzband erfasst wird, die Steuerschaltung so konfiguriert ist, dass sie den Schritt der Energieerfassung mit einem Wiederholungsrhythmus wiederholt, der in Abhängigkeit von Merkmalen mindestens eines HF-Signals, das von der Vorrichtung (100) erfasst und identifiziert werden soll, und/oder einer Belegungsrate des HF-Frequenzbandes angepasst wird.

3. Vorrichtung (100) nach einem der vorstehenden Ansprüche, wobei, wenn ein einzelnes HF-Signal in dem HF-Frequenzband erfasst wird, die Steuerschaltung so konfiguriert ist, dass sie den Schritt der Energieerfassung wiederholt, um die Entwicklung der Energie des erfassten HF-Signals in Abhängigkeit von der Zeit zu definieren, und wobei die Vorrichtung (100) weiter eine oder mehrere Schaltungen (123, 127, 129) zum Bestimmen mindestens eines der folgenden Merkmale auf Grundlage der Werte der Energie des HF-Signals umfasst: Bandbreite, Einschwingzeit, Anfangssteigung, Wert nach Einschwingen, Standardabweichung nach Einschwingen, maximale Amplitude.

4. Vorrichtung (100) nach einem der vorstehenden Ansprüche, die weiter eine Vorrichtung (136) zum Klassifizieren des erfassten HF-Signals mindestens in Abhängigkeit von der ersten und der zweiten Schwellenkreuzungsfrequenz und dem ersten Energiesignal umfasst.

5. Vorrichtung (100) nach einem der vorstehenden Ansprüche, die weiter mindestens einen ersten Bandpassfilter umfasst, dessen obere und/oder untere Grenzfrequenz angepasst werden können, und einen Ausgang umfasst, der mit einem Eingang der ersten Energieerfassungsschaltung (102) gekoppelt ist.

6. Vorrichtung (100) nach Anspruch 5, wobei die Steuerschaltung so konfiguriert ist, dass sie die Schritte der Energieerfassung, der Erfassung der ersten und der zweiten Schwellenkreuzungsfrequenz und des Bestimmens des Vorhandenseins eines einzelnen HF-Signals in dem HF-Frequenzband unter Modifizieren der Werte der oberen und/oder der unteren Grenzfrequenz des ersten Bandpassfilters wiederholt, um diese Schritte für unterschiedliche Teilbänder des HF-Frequenzbandes auszuführen, und/oder um die Bandbreite des ersten Bandpassfilters um eine Mittenfrequenz des einzelnen in dem HF-Frequenzband vorhandenen HF-Signals herum zu zentrieren und zu reduzieren.

7. Vorrichtung (100) nach einem der Ansprüche 1 bis 4, die weiter umfasst:
- mehrere zweite Bandpassfilter (112), die so konfiguriert sind, dass sie eine Filterung in unterschiedlichen Frequenzteilbändern ausführen, die in dem HF-Frequenzband enthalten sind;
- mehrere zweite Energieerfassungsschaltungen (114), die Eingänge umfassen, die mit Ausgängen der zweiten Bandpassfilter (112) gekoppelt sind;
- mehrere dritte Schwellenkreuzungserfassungsschaltungen (113), die Eingänge umfassen, die mit den Ausgängen der zweiten Bandpassfilter (112) gekoppelt sind;
- mehrere vierte Schwellenkreuzungserfassungsschaltungen (122), die Eingänge umfassen, die mit Ausgängen der zweiten Energieerfassungsschaltungen (114) gekoppelt sind;
und wobei die Steuerschaltung so konfiguriert ist, dass sie:
- durch die dritte Schwellenkreuzungserfassungsschaltung (113) eine Erfassung mindestens einer dritten Schwellenkreuzungsfrequenz in den Frequenzteilbändern ausführt;
- durch die zweiten Energieerfassungsschaltungen (114) eine Energieerfassung in den Frequenzteilbändern ausführt;
- durch die vierte Schwellenkreuzungserfassungsschaltung (122) eine Erfassung mindestens einer vierten Schwellenkreuzungsfrequenz von zweiten Energiesignalen ausführt, die am Ausgang der zweiten Energieerfassungsschaltungen (114) bereitgestellt werden;
- mindestens auf Grundlage der dritten und der vierten Schwellenkreuzungsfrequenz und der zweiten Energiesignale das Vorhandensein eines einzelnen HF-Signals in jedem der Frequenzteilbänder bestimmt.

8. Vorrichtung (100) nach Anspruch 7, wobei die obere und/oder die untere Grenzfrequenz der zweiten Bandpassfilter (112) angepasst werden können, und wobei die Steuerschaltung so konfiguriert ist, dass sie die Schritte der Energieerfassung in den Frequenzteilbändern, der Erfassung der dritten und der vierten Schwellenkreuzungsfrequenz und des Bestimmens des Vorhandenseins eines einzelnen HF-Signals in jedem der Frequenzteilbänder unter Modifizieren der Werte der oberen und/oder der unteren Grenzfrequenz der zweiten Bandpassfilter (112) wiederholt, um diese Schritte für unterschiedliche Teilbänder des HF-Frequenzbandes auszuführen, und/oder um die Bandbreiten der zweiten Bandpassfilter (112) um Mittenfrequenzen von HF-Signalen, die in den Frequenzteilbändern vorhanden sind, herum zu zentrieren und zu reduzieren.

9. Vorrichtung (100) nach einem der Ansprüche 7 oder 8, wobei die Steuerschaltung so konfiguriert ist, dass sie die Durchführung der Schritte der Energieerfassung in den Frequenzteilbändern, der Erfassung der dritten und der vierten Schwellenkreuzungsfrequenz und des Bestimmens des Vorhandenseins eines einzelnen HF-Signals in jedem der Frequenzteilbänder unter Auswählen von Zeitpunkten zum Durchführen dieser Schritte so, dass das Vorhandensein eines oder mehrerer unerwünschter Signale in dem am Ausgang der zweiten Bandpassfilter (112) erhaltenen Spektrum verhindert wird, und/oder unter Aufheben eines oder mehrerer zuvor identifizierter Signale wiederholt.

10. Vorrichtung (100) nach einem der vorstehenden Ansprüche, wobei die erste Energieerfassungsschaltung (102) und/oder, wenn die Vorrichtung (100) von einem der Ansprüche 7 bis 9 abhängt, jede zweite Energieerfassungsschaltung (114) eine Schaltung (104, 116) zum Berechnen des Quadrats oder des Absolutwerts eines Signals umfasst, das am Eingang der Energieerfassungsschaltung (102, 114) angelegt wird.

11. Vorrichtung (100) nach Anspruch 10, wobei die erste Energieerfassungsschaltung (102) und/oder, wenn die Vorrichtung (100) von einem der Ansprüche 7 bis 9 abhängt, jede zweite Energieerfassungsschaltung (114) einen Tiefpassfilter (106, 118) umfasst, der einen Eingang umfasst, der mit einem Ausgang der Berechnungsschaltung (104, 116) gekoppelt ist, wobei ein Ausgang des Tiefpassfilters (106, 118) einen Ausgang der Energieerfassungsschaltung (102, 114) bildet.

12. Vorrichtung (100) nach einem der vorstehenden Ansprüche, die weiter mindestens einen ersten Hochpassfilter (108), von dem ein Eingang mit einem Ausgang der ersten Energieerfassungsschaltung (102) gekoppelt ist und von dem ein Ausgang mit einem Eingang der zweiten Schwellenkreuzungserfassungsschaltung (110) gekoppelt ist, und/oder, wenn die Vorrichtung (100) von einem der Ansprüche 7 bis 9 abhängt, mindestens einen zweiten Hochpassfilter (120) umfasst, von dem ein Eingang mit Ausgängen der zweiten Energieerfassungsschaltungen (114) gekoppelt ist und von dem ein Ausgang mit einem Eingang der vierten Schwellenkreuzungserfassungsschaltung (122) gekoppelt ist.

13. Vorrichtung (100) nach Anspruch 12, die weiter eine Spitzenwerterfassungsvorrichtung (125), die einen Eingang umfasst, der mit einem Ausgang des ersten Hochpassfilters (108) gekoppelt ist, und von der ein Ausgang mit einem Eingang einer Schaltung (127) zum Bestimmen eines maximalen Amplitudenwerts gekoppelt ist, und/oder, wenn die Vorrichtung (100) von einem der Ansprüche 7 bis 9 abhängt, mindestens eine zweite Spitzenwerterfassungsvorrichtung (131) umfasst, die einen Eingang umfasst, der mit einem Ausgang des zweiten Hochpassfilters (120) gekoppelt ist, und von der ein Ausgang mit einem Eingang einer Schaltung (133) zum Bestimmen eines maximalen Amplitudenwerts gekoppelt ist.

14. Vorrichtung (100) nach einem der vorstehenden Ansprüche, die weiter umfasst:
- einen rauscharmen Verstärker (126), der einen Eingang umfasst, der dazu bestimmt ist, das oder die HF-Signale, die in dem HF-Frequenzband vorhanden sind, zu empfangen;
- einen Multiplizierer (128), der einen ersten Eingang, der mit dem Ausgang des rauscharmen Verstärkers (126) gekoppelt ist, und einen zweiten Eingang umfasst, der mit einem Ausgang eines lokalen Oszillators (130) gekoppelt ist;
- einen dritten Bandpassfilter (132), der einen Eingang, der mit dem Ausgang des Multiplizierers (128) gekoppelt ist, und einen Ausgang umfasst, der mit dem Eingang der ersten Energieerfassungsschaltung (102) und, wenn die Vorrichtung (100) von einem der Ansprüche 7 bis 9 abhängt, mit dem Eingang der zweiten Energieerfassungsschaltungen (114) gekoppelt ist.

15. Ortungsvorrichtung, die mindestens eine HF-Signalerfassungsvorrichtung nach einem der vorstehenden Ansprüche umfasst.

## Claims

1. An RF signal detection device, including at least:
- a first threshold crossing detection circuit (107) comprising an input coupled to an input of the RF signal detection device (100);
- a first energy detection circuit (102) comprising an input coupled to the input of the RF signal detection device;
- a second threshold crossing detection circuit (110) comprising an input coupled to an output of the first energy detection circuit (102);
and further including a control circuit (140) configured to:
- carry out, by the first threshold crossing detection circuit, detection of at least a first threshold crossing frequency in a predetermined RF frequency band;
- carry out, by the first energy detection circuit (102), energy detection in the predetermined RF frequency band; and
- carry out, by the second threshold crossing detection circuit (110), detection of at least a second threshold crossing frequency of a first energy signal delivered as an output from the first energy detection circuit (102);
- determine, at least from the first and second threshold crossing frequencies and the first energy signal, whether a single RF signal is present in the RF frequency band; and in which each of the threshold crossing detection circuits is configured to count, for a given duration, the number of times the signal applied to its input crosses a threshold value.

2. The RF signal detection device according to claim 1, wherein, when no RF signal is detected in the RF frequency band, the control circuit is configured to repeat the energy detection step with a repetition rate adjusted as a function of features of at least one RF signal to be detected and identified by the RF signal detection device (100) and/or an occupancy rate of the RF frequency band.

3. The RF signal detection device according to anyone of the preceding claims, wherein, when a single RF signal is detected in the RF frequency band, the control circuit is configured to repeat the energy detection step so as to define the change of the energy of said detected RF signal as a function of time, and wherein the RF signal detection device further includes one or more circuits (123, 127, 129) for determining at least one of the following features from the energy values of said RF signal: pass band, settling time, initial slope, post-settling value, post-settling standard deviation, maximum amplitude.

4. The RF signal detection device according to anyone of the preceding claims, further including a device (136) for classifying the detected RF signal at least as a function of the first and second threshold crossing frequencies and the first energy signal.

5. The RF signal detection device according to anyone of the preceding claims, further including at least a first bandpass filter, high and/or low cut-off frequencies of which are adjustable, and comprising an output coupled to an input of the first energy detection circuit.

6. The RF signal detection device according to claim 5, wherein the control circuit is configured to repeat the steps of detecting energy, detecting the first and second threshold crossing frequencies and determining the presence of a single RF signal in the RF frequency band by modifying the values of the high and/or low cut-off frequencies of the first bandpass filter so as to carry out these steps for different sub-bands of the RF frequency band, and/or so as to centre and reduce the pass band of the first bandpass filter around a centre frequency of said single RF signal present in the RF frequency band.

7. The RF signal detection device according to anyone of claims 1 to 4, further including:
- several second bandpass filters (112) configured to carry out filtering in different frequency sub-bands included in the RF frequency band;
- several second energy detection circuits (114) comprising inputs coupled to outputs of the second bandpass filters (112);
- several third threshold crossing detection circuits (113) comprising inputs coupled to outputs of the second bandpass filters (112);
- several fourth threshold crossing detection circuits (122) comprising inputs coupled to outputs of the second energy detection circuits (114);
and wherein the control circuit is configured to:
- carry out, by the third threshold crossing detection circuit, detection of at least a third threshold crossing frequency in the frequency sub-bands;
- carry out, by the second energy detection circuits, energy detection in the frequency sub-bands; and
- carry out, by the fourth threshold crossing detection circuit, detection of at least a fourth threshold crossing frequency of second energy signals delivered as an output from the second energy detection circuits;
- determine, at least from the third and fourth threshold crossing frequencies and the second energy signals, the presence of a single RF signal in each of the frequency sub-bands.

8. The RF signal detection device according to claim 7, wherein high and/or low cut-off frequencies of the second bandpass filters (112) are adjustable, and wherein the control circuit is configured to repeat the steps of detecting energy in the frequency sub-bands, detecting the third and fourth threshold crossing frequencies and determining the presence of a single RF signal in each of the frequency sub-bands by modifying the values of the high and/or low cut-off frequencies of the second bandpass filters so as to carry out these steps for different sub-bands of the RF frequency band, and/or so as to centre and reduce the pass bands of the second bandpass filters around centre frequencies of RF signals present in the frequency sub-bands.

9. The RF signal detection device according to claim 7 or 8, wherein the control circuit is configured to repeat the implementation of the steps of detecting energy in the frequency sub-bands, detecting the third and fourth threshold crossing frequencies and determining the presence of a single RF signal in each of the frequency sub-bands by choosing time instants for implementing these steps so as to avoid the presence of one or more undesired signals in the spectrum obtained as an output of the second bandpass filters (112) and/or cancelling one or more previously identified signals.

10. The RF signal detection device according to anyone of the preceding claims, wherein the first energy detection circuit (102) and/or when the device (100) depends on anyone of claims 7 to 9, each second energy detection circuit (114) includes a circuit (104, 116) for computing the square or absolute value of a signal applied as an input of the first energy detection circuit.

11. The RF signal detection device according to claim 10, wherein the first energy detection circuit (102) and/or when the device (100) depends on anyone of claims 7 to 9, each second energy detection circuit (114) includes a low-pass filter comprising an input coupled to an output of the computational circuit, an output of the low-pass filter forming an output of the energy detection circuit.

12. The RF signal detection device according to anyone of the preceding claims,, further including at least a first high-pass filter (108), an input of which is coupled to an output of the first energy detection circuit and an output of which is coupled to an input of the second threshold crossing detection circuit (110), and/or when the device (100) depends on anyone of claims 7 to 9, at least a second high-pass filter, an input of which is coupled to outputs of the second energy detection circuits and an output of which is coupled to an input of the fourth threshold crossing detection circuit.

13. The RF signal detection device according to claim 14, further including a peak value detection device (125) comprising an input coupled to an output of the first high-pass filter, and an output of which is coupled to an input of a maximum amplitude value determination circuit, and/or when the device (100) depends on anyone of claims 7 to 9, at least a second peak value detection device comprising an input coupled to an output of the second high-pass filter, and an output of which is coupled to an input of a maximum amplitude value determination circuit.

14. The RF signal detection device according to claim 1, further including:
- a low noise amplifier (126) comprising an input for receiving the RF signal or RF signals present in the RF frequency band;
- a multiplier (128) comprising a first input coupled to the output of the low noise amplifier, and a second input coupled to an output of a local oscillator;
- a third bandpass filter (132) comprising an input coupled to the output of the multiplier and an output coupled to the input of the first energy detection circuit and, when the device (100) depends on anyone of claims 7 to 9, to the input of the second energy detection circuits.

15. A locating device including at least one RF signal detection device according to anyone of preceding claims.
